# EUROPEAN PATENT APPLICATION

(11) **EP 4 398 316 A1**
(43) Date of publication of application: **10.07.2024**
(21) Application number: 23216357.6
(22) Date of filing: 13.12.2023
(51) Int. Cl.: H01L 33/00, H01L 33/06, H01L 33/10

(54) **SEMICONDUCTOR ELEMENT, ELECTRONIC DEVICE COMPRISING SEMICONDUCTOR ELEMENT AND SEMICONDUCTOR CHIP**

(30) Priority: 04.01.2023 US 202363436889 P; 01.09.2023 CN 202311119713
(71) Applicant: InnoLux Corporation, Chu-Nan, Miao-Li 350 (TW)
(72) Inventor: HUANG, Wei-Ta, 350 Miao-Li County (TW); LEE, Tzu-Yi, 350 Miao-Li County (TW); KUO, Hao-Chung, 350 Miao-Li County (TW); HUANG, Chun-Hui, 350 Miao-Li County (TW); HSIEH, Tsau-Hua, 350 Miao-Li County (TW)
(74) Representative: Straus, Alexander

(57) **Abstract**

A semiconductor element (100, 100A, 100B, 100C, 100D) includes a quantum well structure (130). The quantum well structure (130) of the semiconductor element (100, 100A, 100B, 100C, 100D) is disposed between a first type semiconductor layer (110) and a second type semiconductor layer (120), and includes a pair of barrier layers (139) and a first active layer (131) and a second active layer (132) disposed between the pair of barrier layers (139). The first active layer (131) and the second active layer (132) respectively include a group 13 elements of different concentrations. The first reflection unit (140) is disposed under the first type semiconductor layer (110). The second reflection (150) unit is disposed on the second type semiconductor layer (120), and defines a resonant cavity (102) with the first reflection unit (140). The quantum well structure (130) is arranged in the resonant cavity (102).

## Description

### Field of the Disclosure

The present disclosure relates to a semiconductor element, an electronic device including the semiconductor element, and a semiconductor chip including the semiconductor element, and in particular to a semiconductor element including Group 13 elements of different concentrations.

### Background of the Disclosure

Commercially gallium nitride grows on a sapphire substrate to form light-emitting diodes (LEDs). This type of growth creates an internal electric field due to asymmetric atom charges. The internal electric field causes the energy band to tilt, and results in a red shift of the wavelength of the main peak (maximum peak) when no (or low) electric field is applied to the light-emitting diode. Later, as the electric current gradually increases, the main peak wavelength of the light-emitting diodes becomes blue-shifted, which results in the shift of the output wavelength of the light-emitting diode due to the change in current, thereby affecting the color stability of the light-emitting diodes.

Since conventional light-emitting diodes do not solve the problem of the shift in emission wavelength as the current changes, it is still needed in the industry to continue the research and the development to overcome the above problems.

### Summary of the Disclosure

In view of these, the present disclosure proposes a semiconductor element, an electronic device including the semiconductor element, and a semiconductor chip including the semiconductor element, which may solve the technical problems currently encountered in the field. This is achieved by a semiconductor element, an electronic device including the semiconductor element, and a semiconductor chip including the semiconductor element according to the claims. The dependent claims pertain to corresponding further developments and improvements.

As will be seen more clearly from the detailed description following below, a semiconductor element including a first type semiconductor layer, a second type semiconductor layer, a quantum well structure, a first reflection unit and a second reflection unit is provided by the present disclosure. The quantum well structure is disposed between the first type semiconductor layer and the second type semiconductor layer and includes a pair of barrier layers as well as a first active layer and a second active layer which are disposed between the pair of barrier layers. The first active layer and the second active layer respectively include Group 13 elements of different concentrations. The first reflection unit is disposed under the first type semiconductor layer. The second reflection unit is disposed on the second type semiconductor layer and defines a resonant cavity with the first reflection unit. The quantum well structure is arranged in the resonant cavity.

An electronic device including a circuit substrate and the above-described semiconductor element provided on the circuit substrate is provided by the present disclosure.

A semiconductor chip including two semiconductor elements is provided by the present disclosure. Each one of the semiconductor elements may include a first type semiconductor layer, a second type semiconductor layer, a quantum well structure, a first reflection unit and a second reflection unit. The quantum well structure is disposed between the first type semiconductor layer and the second type semiconductor layer and includes a pair of barrier layers as well as a first active layer and a second active layer which are disposed between the pair of barrier layers. The first active layer and the second active layer respectively include Group 13 elements of different concentrations. The first reflection unit is disposed under the first type semiconductor layer. The second reflection unit is disposed on the second type semiconductor layer and defines a resonant cavity with the first reflection unit. The quantum well structure is arranged in the resonant cavity.

The present disclosure provides a light-emitting diode structure which helps reduce the wavelength shift of the light-emitting diodes when operated at high/low electric currents. A semiconductor element according to some embodiments of the present disclosure, the first active layer and the second active layer respectively include Group 13 elements of different concentrations, which is beneficial to converging the wavelength shift of the light-emitting diodes and maintaining the color quality of the light-emitting diodes. The resonant cavity which is defined by the first reflection unit and the second reflection unit is conducive to limit the wavelength shift of the light-emitting diodes and maintain the color quality of the light-emitting diodes. In this way, the two may work together to have a synergistic effect and improve the color stability of the light-emitting diode, which is beneficial to the technological progress and innovation of semiconductor elements.

These and other objectives of the present disclosure will no doubt become obvious to those of ordinary skill in the art after reading the following detailed description of the embodiment that is illustrated in the various figures and drawings.

### Brief Description of the Drawings

In the following, the disclosure is further illustrated by way of example, taking reference to the accompanying drawings. Thereof:
FIG. 1 is a cross-sectional view of a schematic structural diagram of a semiconductor element according to a first embodiment of the present disclosure;
FIG. 2 and FIG. 3 are cross-sectional views of schematic structural diagrams of a possible implementation of the quantum well structure in the semiconductor element according to the second embodiment of the present disclosure;
FIG. 4 is a cross-sectional view of a schematic structural diagram of a possible implementation of the quantum well structure in the semiconductor element according to the third embodiment of the present disclosure;
FIG. 5 is a schematic diagram of the change of the optical power (W/m) versus the element current (mA) of the quantum well structure of the semiconductor element according to the fourth embodiment of the present disclosure;
FIG. 6 is a schematic diagram of the change of the internal quantum efficiency (IQE) versus the element current of the quantum well structure of the semiconductor element according to the fifth embodiment of the present disclosure;
FIG. 7 is a schematic diagram showing the shifts of the main peak wavelength of the quantum well structure of the semiconductor element versus different element currents according to the sixth embodiment of the present disclosure;
FIG. 8 and FIG. 9 are some cross-sectional views of schematic structural diagrams of some possible implementations of the reflection unit in the semiconductor element according to the seventh embodiment of the present disclosure;
FIG. 10 is a schematic diagram of the change of luminous intensity (a.u.) versus emission wavelength (nm) of the semiconductor element according to the eighth embodiment of the present disclosure;
FIG. 11 is a cross-sectional image of a scanning electron microscope (SEM) of a possible implementation structure of the first reflection unit or the second reflection unit in the semiconductor element according to the ninth embodiment of the present disclosure;
FIG. 12 is a schematic diagram showing changes of luminous intensity (a.u.) versus the element current of the semiconductor element with a thin film filter structure according to the tenth embodiment of the present disclosure compared to a light-emitting device with a conventional quantum well;
FIG. 13 and FIG. 14 are cross-sectional views of schematic structural diagrams of possible implementations of the electronic device according to the eleventh embodiment of the present disclosure;
FIG. 15 is a cross-sectional view of a schematic structural diagram of a possible implementation of a semiconductor chip according to the twelfth embodiment of the present disclosure;
FIG. 16 is a cross-sectional view of a schematic structural diagram of a possible implementation of a semiconductor chip according to the thirteenth embodiment of the present disclosure.

### Detailed Description

The present disclosure may be understood by reference to the following detailed description, taken in conjunction with the drawings as described below. It is noted that, for purposes of illustrative clarity and being easily understood by the readers, various drawings of this disclosure show a portion of the electronic device, and certain elements in various drawings may not be drawn to scale. In addition, the number and dimension of each device shown in drawings are only illustrative and are not intended to limit the scope of the present disclosure.

Certain terms are used throughout the description and following claims to refer to particular components. As one skilled in the art will understand, electronic equipment manufacturers may refer to a component by different names. This document does not intend to distinguish between components that differ in name but not function. In the following description and in the claims, the terms "include", "comprise" and "have" are used to specify the presence of stated features, regions, steps, operations and/or elements and does not exclude the presence or addition of one or more other features, regions, steps, operations, elements and/or combinations thereof.

When a component or a film layer is referred to as "disposed on another component or another film layer" or "extended to another component or another film layer", it can mean that the component or film layer is directly disposed on another component or film layer, or directly extended to another component or film layer, or there may be other components or film layers in between. In contrast, when a component is said to be "directly disposed on another component or film" or "directly extended to another component or film", there is no component or film between the two.

When an element is referred to as "connected to" another element in some embodiment of the present disclosure, it can mean that the element directly contacts another element, or indirectly contacts another element via one or more other elements between the two elements.

The terms "about", "substantially", "equal", or "same" generally mean within 20% of a given value or range, or mean within 10%, 5%, 3%, 2%, 1%, or 0.5% of a given value or range.

Although terms such as first, second, third, etc., may be used to describe diverse constituent elements, such constituent elements are not limited by the terms. The terms are used only to discriminate a constituent element from other constituent elements in the specification. The claims may not use the same terms, but instead may use the terms first, second, third, etc. with respect to the order in which an element is claimed. Accordingly, in the following description, a first constituent element may be a second constituent element in a claim.

The technical features in different embodiments described in the following may be replaced, recombined, or mixed with one another to constitute another embodiment without departing from the spirit of the present disclosure.

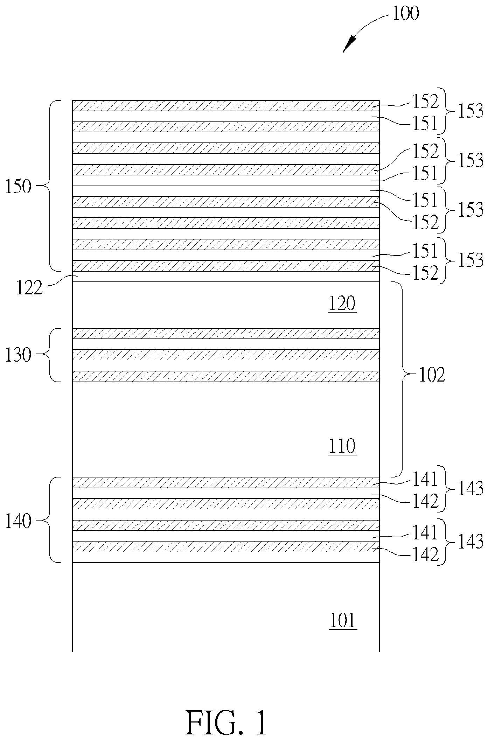

FIG. 1 is a cross-sectional view of a schematic structural diagram of a semiconductor element 100 according to a first embodiment of the present disclosure. The semiconductor element 100 may be a light-emitting element, including, for example, an optional substrate 101, a first type semiconductor layer 110, a second-type semiconductor layer 120, a transparent conductive layer 122, a quantum well structure 130, a first reflection unit 140, and a second reflection unit 150. The optional substrate 101 may be a substrate of an organic material or a substrate of an inorganic material. In some embodiments, the substrate of an inorganic material may include, for example, a patterned or unpatterned sapphire substrate, or may include a conductive material, such as a copper substrate, but the present disclosure is not limited thereto.

The light-emitting device including the semiconductor element 100 may include a display device, a lighting device or a splicing device, but the present disclosure is not limited thereto. The semiconductor element 100 may be applied in an electronic device, and the electronic device may be a foldable electronic device, a curved electronic device, a free-shaped electronic device or a flexible electronic device, but the present disclosure is not limited thereto. In some embodiments, the electronic device includes a display device or a light-emitting device, and the display medium thereof may be a liquid crystal (LC), an organic light-emitting diode (OLED), a sub-millimeter light-emitting diode (mini LED), or a micro light-emitting diode (micro LED), a quantum dot light-emitting diode (QLED), a quantum dot (QD), phosphor, fluorescent material or other suitable display elements, or an optional combination of these materials, but the present disclosure is not limited thereto. Please note that the electronic device which the semiconductor element 100 is used in may be an optional combination of the above, but the present disclosure is not limited thereto. In the following description, a micro light-emitting diode is taken as an example of the semiconductor element 100, but the present disclosure is not limited thereto. The semiconductor element 100 may be used to emit blue light of a main peak (maximum peak) wavelength in a range of 420 nanometers (nm) to 460 nanometers, or to emit green light of a main peak wavelength in a range of 510 nanometers to 540 nanometers to obtain better optical performance, but the present disclosure is not limited thereto. The chip size of light-emitting diodes is about 300 µm to 10 mm, the chip size of sub-millimeter light-emitting diodes is about 100 µm to 300 µm, and the chip size of micro-light-emitting diodes is about 1 µm to 100 µm, but the present disclosure is not limited thereto.

One of the first type semiconductor layer 110 and the second type semiconductor layer 120 may be, for example, an N-type semiconductor layer, and the other may be, for example, a P-type semiconductor layer. The first type semiconductor layer 110 and the second type semiconductor layer 120 may include, for example, gallium nitride (GaN) or other suitable semiconductor materials. The quantum well structure 130 is disposed between the first type semiconductor layer 110 and the second type semiconductor layer 120. In the embodiment shown in FIG. 1, the first type semiconductor layer 110 is disposed under the second type semiconductor layer 120. The first reflection unit 140 is disposed under the first type semiconductor layer 110. For example, the first type semiconductor layer 110 may be sandwiched between the first reflection unit 140 and the quantum well structure 130. The second reflection unit 150 is disposed on the transparent conductive layer 122 above the second type semiconductor layer 120. For example, the second type semiconductor layer 120 may be sandwiched between the second reflection unit 150 and the quantum well structure 130. Or alternatively, the transparent conductive layer 122 may be sandwiched between the second type semiconductor layer 120 and the second reflection unit 150. The transparent conductive layer 122 may include, for example, indium tin oxide (ITO) or indium gallium zinc oxide (IGZO), but the present disclosure is not limited thereto.

According to some embodiments of the present disclosure, the semiconductor element 100 may be a resonant cavity light-emitting diode (RC-LED). The resonant cavity light-emitting diode mainly consists of three parts: an upper and lower distributed Bragg reflector (DBR)/mirror, an active region and a resonant cavity. In the semiconductor element 100, a space between the first reflection unit 140 and the second reflection unit 150 is defined as a resonant cavity 102. The height of the resonant cavity 102 is the distance between the first reflection unit 140 and the second reflection unit 150. The quantum well structure 130 is disposed in the active region in the resonant cavity 102 and is composed of multiple layers of periodically stacked direct band gap materials and makes the semiconductor element 100 generate high-purity monochromatic light of a narrow emission spectrum according to the optical conditions defined by the first reflection unit 140 and by the second reflection unit 150.

The first reflection unit 140 and the second reflection unit 150 may respectively be distributed Bragg reflectors. The upper distributed Bragg reflector and the lower distributed Bragg reflector may be respectively made of dielectric materials or of metals. Specifically, the first reflection unit 140 and the second reflection unit 150 may respectively be composed of a group of different dielectric materials which periodically overlap each other and have different refractive indexes. According to some embodiments of the present disclosure, the first reflection unit 140 may include alternately stacked first lower reflection unit layers 141 and second lower reflection unit layers 142 to form a plurality of sets of lower reflection unit stack layers 143. One of the first lower reflection unit layer 141 and the second lower reflection unit layer 142 may be, for example a doped semiconductor, and the other may be, for example, an undoped semiconductor. The doped semiconductor layer may include a first type semiconductor layer or a second-type semiconductor layer, such as an N-type semiconductor layer or a P-type semiconductor layer. The first lower reflection unit layer 141 and the second lower reflection unit layer 142 may include, for example, gallium nitride or other suitable semiconductor materials. According to some embodiments of the present disclosure, the second reflection unit 150 may include alternately stacked first upper reflection unit layers 151 and second upper reflection unit layers 152 to form a plurality of sets of upper reflection unit stack layers 153. The first upper reflection unit layer 151 and the second upper reflection unit layer 152 may respectively include different dielectric materials. For example, one of them may be tantalum oxide, and the other may be silicon oxide, for example, but the present disclosure is not limited thereto.

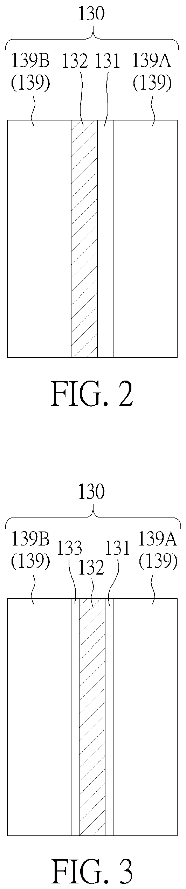

FIG. 2 and FIG. 3 are cross-sectional views of schematic structural diagrams of a possible implementation of the quantum well structure 130 in the semiconductor element 100 according to the second embodiment of the present disclosure. The main difference between the quantum well structure 130 in the semiconductor element 100 in FIG. 2 and the quantum well structure 130 in the semiconductor element 100 in FIG. 3 is an optional third active layer 133 shown in FIG. 3 .

The quantum well structure 130 in the semiconductor element 100 may include a pair of barrier layers 139, a first active layer 131, a second active layer 132, and an optional third active layer 133. The pair of barrier layers 139 may include a first barrier layer 139A and a second barrier layer 139B. The pair of barrier layers 139 may respectively include a semiconductor material, such as gallium nitride. The first active layer 131 and the second active layer 132 are located between the pair of barrier layers 139. In some embodiments, the first barrier layer 139A and the second barrier layer 139B respectively directly contact the first active layer 131 or the second active layer 132. For example, the first barrier layer 139A directly contacts the first active layer 131, and the second barrier layer 139B directly contacts the second active layer 132. Alternatively, the second barrier layer 139B directly contacts the first active layer 131, and the first barrier layer 139A directly contacts the second active layer 132. According to some embodiments of the present disclosure, the first active layer 131 and the second active layer 132 may respectively include, for example, gallium nitride semiconductor materials and Group 13 elements of different concentrations. Group 13 elements represent the Group 13 elements in the periodic table, and may specifically include boron, aluminum, gallium, indium, and thallium. For example, the indium concentration of the first active layer 131 is higher than that of the second active layer 132. Alternatively, the indium concentration of the first active layer 131 is lower than that of the second active layer 132. The absolute value of the indium concentration difference between the first active layer 131 and the second active layer 132 is not a characteristic of the quantum well structure 130 of the present disclosure. One of the characteristics of the quantum well structure 130 of the present disclosure resides in the indium concentration of the first active layer 131 different from the indium concentration of second active layer 132.

According to some embodiments of the present disclosure, the first barrier layer 139A may also directly contact the optional third active layer 133, so that the second active layer 132 is sandwiched between the first active layer 131 and the third active layer 133. According to some embodiments of the present disclosure, the third active layer 133 may include, for example, a gallium nitride semiconductor material, with a Group 13 element concentration which is different from that of the second active layer 132. For example, the indium concentration of the third active layer 133 is lower than that of the second active layer 132, and the indium concentration of the first active layer 131 is lower than that of the second active layer 132. The absolute value of the difference between the indium concentration of the first active layer 131 or of the third active layer 133 and the indium concentration of the second active layer 132 is not a characteristic of the quantum well structure 130 of the present disclosure. The quantum well structure 130 of the present disclosure is characterized in that the indium concentration of the first active layer 131 or the indium concentration of the third active layer 133 is different from the indium concentration of the second active layer 132.

According to some embodiments of the present disclosure, the indium to gallium ratio of the first active layer 131 may be 0.155/0.845, the indium to gallium ratio of the second active layer 132 may be 0.33/0.67, and the indium to gallium ratio of the third active layer 133 may be 0.155/0.845, but the present disclosure is not limited thereto. The thickness of the first active layer 131 or of the third active layer 133 may be different from the thickness of the second active layer 132. For example, the thickness of the first active layer 131 may be 0.7 nm, the thickness of the third active layer 133 may be 0.7 nm, and the thickness of the second active layer 132 may be 2.1 nm, but the present disclosure is not limited thereto. The staggered quantum well structure of the present disclosure may optimize the energy band structure of the light-emitting quantum well, and may achieve the advantages of reducing wavelength shift, increasing optical output power, and improving quantum efficiency.

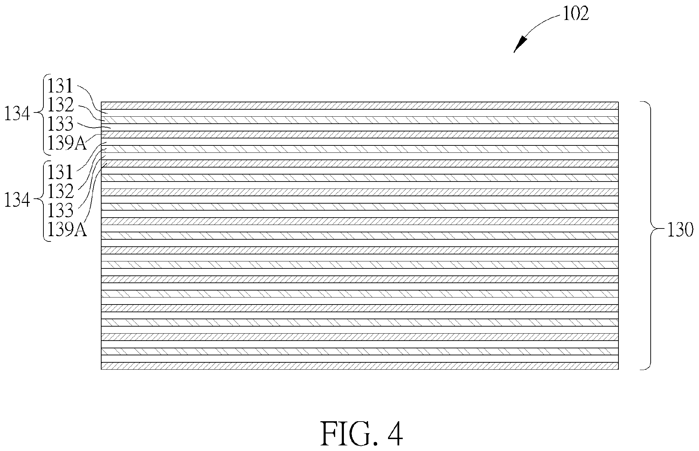

FIG. 4 is a cross-sectional view of a schematic structural diagram of a possible implementation of the quantum well structure 130 in the semiconductor element 100 according to the third embodiment of the present disclosure. The main difference between the quantum well structure 130 in the semiconductor element 100 in FIG. 4 and the quantum well structure 130 in the semiconductor element 100 in FIG. 3 resides in the multiple sets of stacked active layers 134 in FIG. 4. The emitting layer (EML) of the combining region of the light-emitting region of the semiconductor element 100 is located in the resonant cavity 102. FIG. 4 shows 9 sets of stacked active layers 134, but the present disclosure is not limited thereto.

Each set of stacked active layers 134 may include a layer of a first active layer 131, of a second active layer 132, of a third active layer 133 and of a first barrier layer 139A. Every three layers of these active layers are stacked to form a single set of stacked active layer 134. The quantum well structure 130 in the semiconductor element 100 may optionally include one or more sets of stacked active layers 134. Multiple sets of stacked active layers 134 in the quantum well structure 130 form a staggered quantum well (QW) structure, that is, an indium gallium nitride/gallium nitride quantum well system. This is a staggered quantum well structure in which indium gallium nitride of a relatively higher indium concentration is sandwiched between several layers of indium gallium nitride of a lower indium concentration.

The following is a comparison of some optical performances of the staggered quantum well structure of the present disclosure with a traditional commercial light-emitting diode and with a traditional light-emitting diode of a pre-well structure. The efficiency difference at 40mA means the difference between the internal quantum efficiency value at an element current 40mA and the extreme value of its internal quantum efficiency of the light-emitting diode.

| Type | Maximal Optical Output Power at 40 mA(W/m) | Efficiency Difference at 40mA | Wavelength Shift (nm) |
|---|---|---|---|
| Traditional Commercial LED | 17.99 | 0.6303 | 9.04 |
| LED of Traditional Pre-well Structure | 47.15 | 0.4492 | 6.02 |
| Staggered QW Structure | 72.88 | 0.1878 | 3.01 |

From the above comparisons, it is shown that the staggered quantum well structure of the present disclosure has an optical output power gain of 305% and 54.6%, 70.2% and 58.2% smaller efficiency differences at 40 mA, and 66.7% and 50% smaller wavelength shifts respectively compared with the traditional commercial light-emitting diode and with the light-emitting diode of traditional pre-well structures. It is suggested that the staggered quantum well structure of the present disclosure may exhibit significantly better optical performance compared with the traditional commercial light-emitting diode and with the light-emitting diode of traditional pre-well structures.

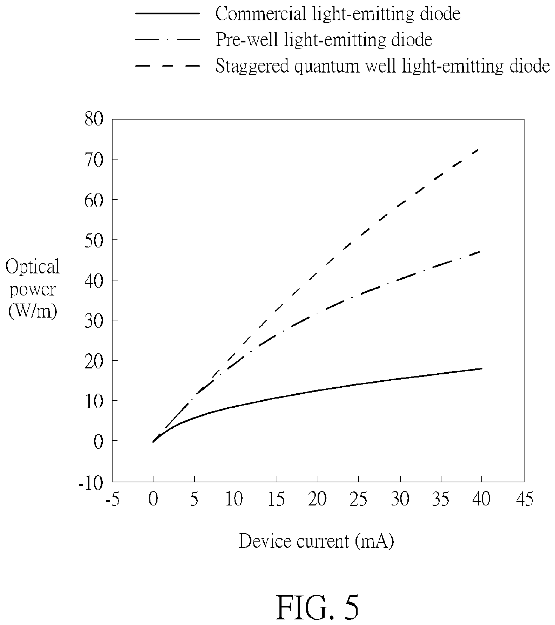

FIG. 5 is a schematic diagram of the change of the optical power (W/m) versus the device current (mA) of the quantum well structure 130 of the semiconductor element 100 according to the fourth embodiment of the present disclosure. FIG. 5 also provides a curve of the optical power versus the device currents of a traditional commercial light-emitting diode and of a light-emitting diode with a traditional pre-well structure for comparison. On one hand, the conventional commercial quantum well of a light-emitting diode includes staggered stacks of semiconductor layers and active layers. The semiconductor layer is made of gallium nitride material, and the active layer is made of indium gallium nitride. On the other hand, the quantum well of a light-emitting diode of the traditional pre-well structure includes multiple layers of staggered stacked active stacking layers. Each active stacking layer includes a semiconductor layer and an active layer. The semiconductor layer is made of gallium nitride material, and the active layer is made of indium gallium nitride. The indium concentrations in the active layers in the multiple active stacking layers may not be the same. The number of active stacking layers with the active layers of the same indium concentration may not be the same, either.

It is shown from the three curves with different results in FIG. 5 that the optical power may steadily increase as the device current increases because the semiconductor element 100 of the present disclosure has a staggered quantum well structure. In the high current region of up to 30mA-40mA, the optical power of the semiconductor element 100 of the present disclosure may still steadily increase with the rise of the device current without the problem of saturation. On one hand, the optical power of the light-emitting diode with traditional pre-well structure shows fatigue in the high current region. On the other hand, the optical power of the traditional commercial light-emitting diode obviously exhibits the problem of premature saturation as the device current increases.

From the comparative performance, it is suggested that the optical power of the semiconductor element 100 of the present disclosure may show an excellent positive correlation with the device current without the problem of saturation of the optical power at high currents, compared with the optical power of the light-emitting diode of the traditional pre-well structure, or compared with the traditional commercial light-emitting diode. This is one of the inventive steps of the semiconductor element 100 of the present disclosure.

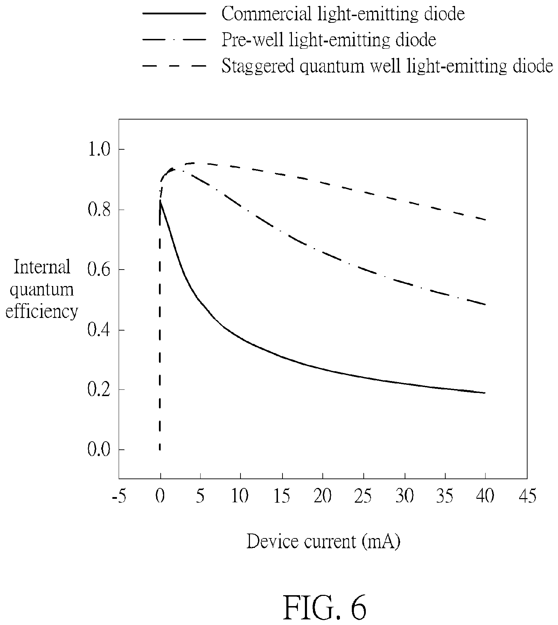

FIG. 6 is a schematic diagram of the change of the internal quantum efficiency (IQE) versus the device current of the quantum well structure 130 of the semiconductor element 100 according to the fifth embodiment of the present disclosure. FIG. 6 also provides some curves for the comparison of the internal quantum efficiency versus the device current of the traditional commercial light-emitting diode and of the light-emitting diode of the traditional pre-well structure. The internal quantum efficiency may be roughly simplified as the efficiency of electrons of a component converted into photons. It is shown from the three curves with different results in FIG. 6 that the internal quantum efficiency of the semiconductor element 100 of the present disclosure does not drop rapidly as the device current rises. Especially in the high current region of up to 30mA-40mA, the internal quantum efficiency of the semiconductor element 100 of the present disclosure may still maintain an excellent output higher than 0.7. On one hand, the internal quantum efficiency of the light-emitting diode with the traditional pre-well structure shows fatigue in the high current region. For example, in the high current region of 40mA, its internal quantum efficiency decays to less than 0.5. On the other hand, the internal quantum efficiency of the traditional commercial light-emitting diode significantly and rapidly decays as the device current increases. For example, in the high current region of 40mA, its internal quantum efficiency decays to less than 0.2.

It is suggested from the comparative performance that the internal quantum efficiency of the semiconductor element 100 of the present disclosure shows excellent high efficiency, especially at high current, the internal quantum efficiency is not significantly suppressed, compared with the internal quantum efficiency of the light-emitting diode with the traditional pre-well structure, or compared with the traditional commercial light-emitting diode. This is another inventive step of the semiconductor element 100 of the present disclosure.

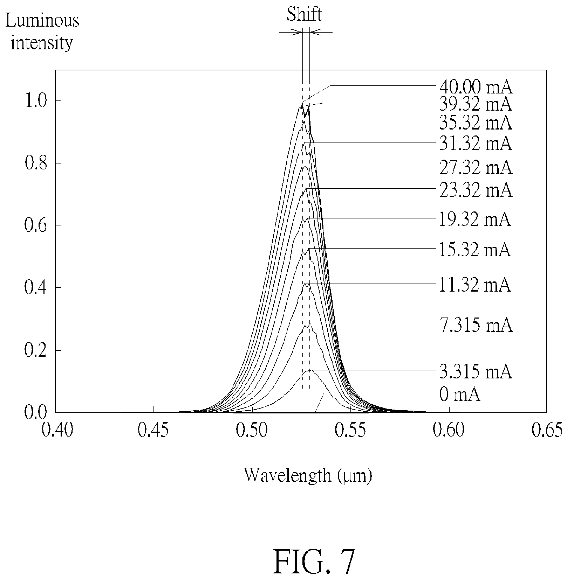

FIG. 7 is a schematic diagram showing the shifts of the main peak wavelength of the quantum well structure 130 of the semiconductor element 100 versus different device currents according to the sixth embodiment of the present disclosure. It is shown from the multiple curves of different device currents in FIG. 7 that the main peak wavelength of the semiconductor element 100 of the present disclosure does not shift significantly as the device current increases. Especially at a high current of up to 40 mA, the main peak wavelength of the semiconductor element 100 of the present disclosure only has a shift of about 3.01 nanometers relative to the main peak wavelength at the lowest current of 3.315 mA. On one hand, for the light-emitting diode with the traditional pre-well structures, the main peak wavelength of the highest current of 40mA shifts as many as 6.02 nanometers from the main peak wavelength at the lowest current of 1.339mA (not shown in the figure). On the other hand, for the traditional commercial light-emitting diode, the shift between the main peak wavelength at the highest current of 40mA and the main peak wavelength at the lowest current of 2.372mA is as many as 9.04 nanometers (not shown).

It is suggested from the comparative performance that the quantum well structure 130 of the semiconductor element 100 of the present disclosure may effectively suppress the shift of the output wavelength, compared with the quantum well of the light-emitting diode with the traditional pre-well structure, or compared with the traditional commercial light-emitting diode. This is yet another inventive step of the semiconductor element 100 of the present disclosure.

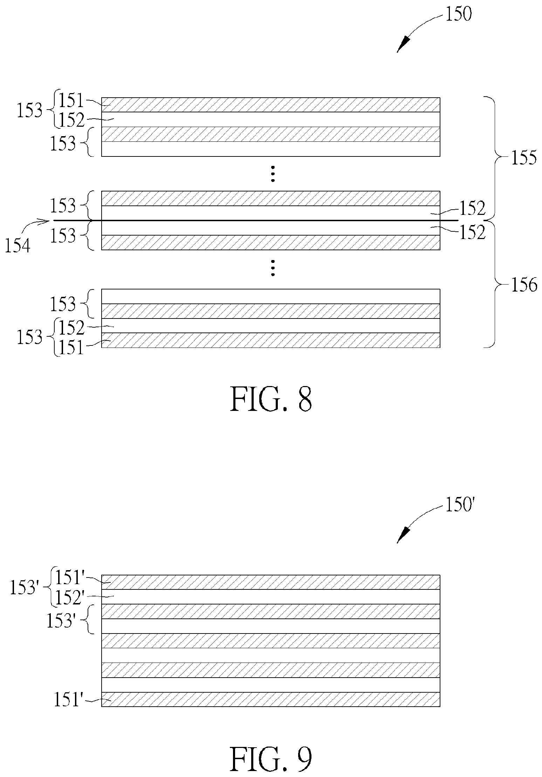

FIG. 8 and FIG. 9 are some cross-sectional views of schematic structural diagrams of some possible implementations of the reflection unit in the semiconductor element 100 according to the seventh embodiment of the present disclosure. FIG. 8 illustrates a possible implementation of the second reflection unit 150 in the semiconductor element 100 of the present disclosure. FIG. 9 illustrates a possible implementation of a reflection unit in a conventional light-emitting device.

As shown in FIG. 8, the second reflection unit 150 in the semiconductor element 100 may be a distributed Bragg reflector. According to some embodiments of the present disclosure, the second reflection unit 150 includes a first Bragg reflector 155, a second Bragg reflector 156 and a middle layer 154 between the two. For example, the first Bragg reflector 155 or the second Bragg reflector 156 may also respectively include a plurality of symmetrically mirror-arranged upper reflection unit stack layers 153. The above-mentioned distributed Bragg reflectors have a film-filter structure to serve as a filter. By controlling the appropriate number of stacked layers of the films, the noise wavelength to be filtered may be designed, so the filtered light wave width may be further limited, and it helps to obtain monochromatic light with particularly narrow full width at half maxima (FWHM) of the main peak (maximum peak) of the emitted light to obtain better optical performance.

The plurality of mirror-arranged upper reflection unit stack layers 153 may be, for example, symmetrically mirror-arranged upper reflection unit stack layers 153 which are arranged according to the middle layer 154 as the mirror axis in the second reflection unit 150, such that there are two layers of the first upper reflection unit layer 151 or of the second upper reflection unit layer 152 which are in direct contact with the second reflection unit 150. FIG. 8 illustrates that the second reflection unit 150 includes 18 sets of upper reflection unit stack layers 153 which are alternately stacked, and in which 9 sets of upper reflection unit stack layers 153 are symmetrically arranged with the other 9 sets of upper reflection unit stack layers 153 according to the middle layer 154 serving as the mirror axis, wherein there are two second upper reflection unit layers 152 in direct contact with the second reflection unit 150, but the present disclosure is not limited thereto.

As shown in FIG. 9, the reflection unit 150' in the traditional light-emitting device has a traditional distributed Bragg reflector. The reflection unit 150' includes a reflection unit stack layer 153', and the reflection unit stack layer 153' includes a first reflection unit layer 151' and a second reflection unit layer 152'. There are an odd number of reflection unit layers in total, so there is no mirror symmetry axis present. FIG. 9 shows 9 alternately stacked reflection unit layers.

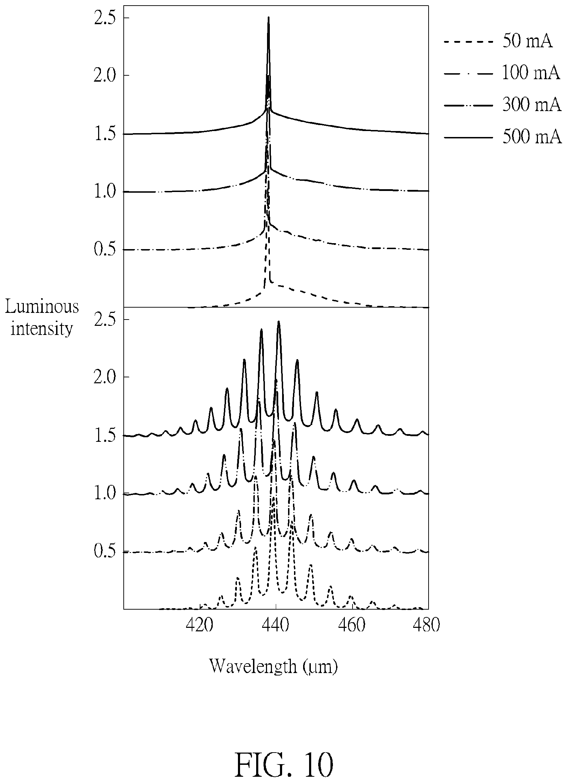

FIG. 10 is a schematic diagram of the change of luminous intensity (a.u.) versus emission wavelength (nm) of the semiconductor element 100 according to the eighth embodiment of the present disclosure, wherein the semiconductor element 100 of the present disclosure may include the structure of the reflection unit shown in FIG. 8. The lower part in FIG. 10 shows the emission peak wavelength generated by a light-emitting device using a conventional distributed Bragg reflector at different element currents. The upper part in FIG. 10 shows the emission peak wavelength generated by a light-emitting device using the distributed Bragg reflector of the present disclosure at different element currents.

It is observed from the four different curves of the device currents in the upper part of FIG. 10 that the number of main peak of the semiconductor element 100 of the present disclosure is quite simple, and only shows a single main peak with a particularly narrow full width at half maxima (FWHM) value. The main peak wavelength does not shift significantly as the device current increases, so it has better wavelength stability. Especially at a high current of up to 500 mA, the main peak wavelength of the semiconductor element 100 of the present disclosure only shifts by about 0.2 nanometers relative to the main peak wavelength of a low current of 50 mA. However, the number of main peaks of a light-emitting device using a traditional distributed Bragg reflector is quite complicated, with multiple main peaks, thus weakening the intensity of the largest main peak. At the same time, the maximum main peak wavelength shifts significantly as the device current increases. Especially at a high current of up to 500 mA, the main peak wavelength of the light-emitting device using the traditional distributed Bragg reflector shifts by up to 1.5 nanometers compared to the main peak wavelength of a low current of 50 mA, which is 7.5 times greater than that of the semiconductor element 100 of the present disclosure.

It is suggested from the comparative performance that the number of main peaks of the semiconductor element 100 of the present disclosure is much less than the number of main peaks of the light-emitting device with traditional distributed Bragg reflectors. In addition, the amount of the shift of the main peak wavelength of the light-emitting device using the traditional distributed Bragg reflectors at high and low currents is 7.5 times greater than that of the semiconductor element 100 of the present disclosure under the same conditions. This is again another one of the inventive steps of the semiconductor element 100 of the present disclosure.

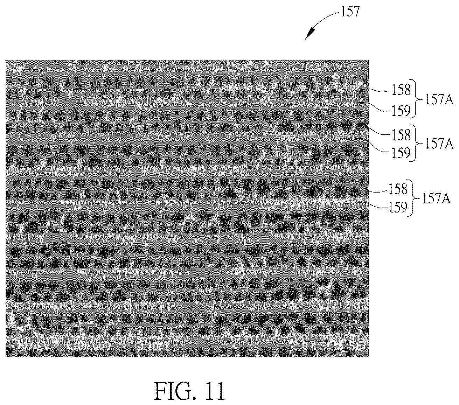

FIG. 11 is a cross-sectional image of a scanning electron microscope (SEM) of a possible implementation structure of the first reflection unit 140 or the second reflection unit 150 in the semiconductor element 100 according to the ninth embodiment of the present disclosure. The first reflection unit 140 and/or the second reflection unit 150 may be a nano-porous Bragg reflector. For example, the first Bragg reflector 155 and the second Bragg reflector 156 may be nano-porous Bragg reflectors, but the present disclosure is not limited thereto. The nano-porous Bragg reflectors help increase the light extraction efficiency (LEE) of the semiconductor element 100 and serves as a stress relief buffer layer to relief the quantum-confined Stark effect, thereby improving the external quantum efficiency of the semiconductor element 100.

The nano-porous Bragg reflector 157 may include multiple sets of porous Bragg reflection stack layers 157A, and each set of porous Bragg reflection stack layers may include doped nano-porous semiconductor layers 158 and undoped nano-porous semiconductor layer 159. The semiconductor layer may include gallium nitride or other suitable semiconductor materials, such as a plurality of alternately stacked nano-porous gallium nitride layers and non-porous gallium nitride layers. The doped semiconductor layer may include, for example, a first type semiconductor layer or a second type semiconductor layer. In some embodiments, the doped semiconductor layer may be, for example, an N-type doped gallium nitride layer, a P-type doped gallium nitride layer, or a composite layer of an N-type doped gallium nitride layer and a P-type doped gallium nitride layer. The refractive index contrast and the applicable emission wavelengths between the doped nano-porous semiconductor layer 158 and the undoped non-porous semiconductor layer 159 may be adjusted by adjusting the porosity of the doped nano-porous semiconductor layer 158 or the numbers of layers or the thickness of the porous Bragg reflection stack layers 157A so that the semiconductor element 100 of the present disclosure is suitable for various emission wavelengths. Porosity is defined as the ratio of the volume of pores to the total volume of the material. For example, the doped nano-porous semiconductor layer 158 with porosity between 30% and 40% is suitable for the green light semiconductor element 100, but the present disclosure is not limited thereto. When the porosity of the doped nano-porous semiconductor layer 158 is 35.7%, it results in a refractive index contrast 1.7/2.39 between the doped nano-porous semiconductor layer 158 and the undoped non-porous semiconductor layer 159, but this disclosure is not limited thereto.

The following example proposes a possible etching process for producing the doped nano-porous gallium nitride layer of the present disclosure, but the present disclosure is not limited thereto. First, a doped gallium nitride layer is provided, for example, an N-type doped gallium nitride layer, a P-type doped gallium nitride layer, or a composite layer of an N-type doped gallium nitride layer and a P-type doped gallium nitride layer combined together. Next, a metallic electrode contact point is formed on the doped gallium nitride layer, for example, an indium contact point. Then, the doped gallium nitride layer with the electrode contact is immersed in the etching solution together with an inert electrode. The etching solution is, for example, an acidic solution including nitrate. Next, the electrode contact point and the inert electrode are connected to an appropriate etching voltage, such as 8V, to initiate the etching step of the doped gallium nitride layer. The appropriate porosity of the nano-porous semiconductor layer may be adjusted by adjusting the etching voltage, the etching time, the concentration of the etching solution, and/or the composition of the etching solution. After reaching a predetermined porosity, the completed nano-porous semiconductor layer is taken out. The nano-porous semiconductor layer is rinsed with deionized water for about 5 minutes, and then blown dry with nitrogen, thereby obtaining a doped nano-porous gallium nitride layer with a predetermined porosity.

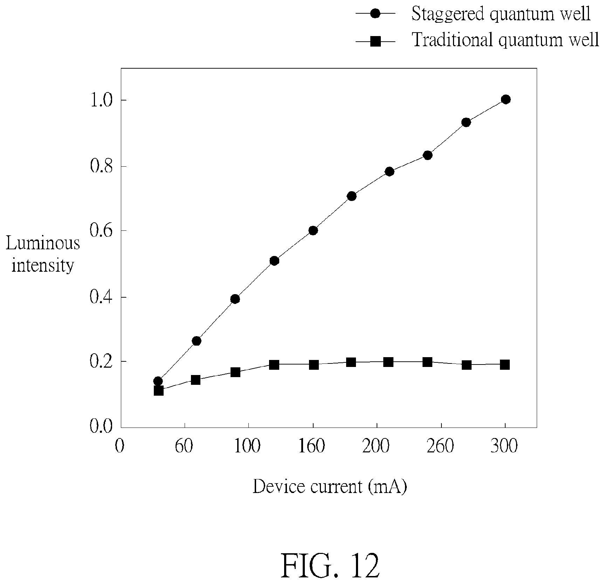

FIG. 12 is a schematic diagram showing changes of luminous intensity (a.u.) versus the device current of the semiconductor element 100 with a thin film filter structure according to the tenth embodiment of the present disclosure compared to a light-emitting device with a conventional quantum well. It is observed from the different curves in FIG. 12 that the luminous intensity of the semiconductor element 100 of the present disclosure roughly increases as the device current increases. Especially at high currents up to as high as 200mA-300mA, the luminous intensity of the semiconductor element 100 of the present disclosure may obviously increase as the device current increases. However, the luminous intensity of the light-emitting device using the traditional quantum well obviously does not increase as the device current increases. Especially at high currents, the luminous intensity of the traditional light-emitting device prematurely saturates without substantial increase.

It is suggested from the comparative performance that the luminous intensity of the semiconductor element 100 of the present disclosure may obviously increase as the device current increases, without the presence of premature saturation of the luminous intensity of the traditional light-emitting device, which is another inventive step of the semiconductor element 100 of the present disclosure.

According to the semiconductor element 100 of the present disclosure, the active region of the semiconductor element 100 starts to emit light spontaneously when the input current exceeds the threshold current. Most of the emitted light resonates in the space of the resonant cavity 102 defined between the first reflection unit 140 of the Bragg reflector and the second reflection unit 150 of the Bragg reflector. Only a small part of the emitted light escapes from the space of the resonant cavity 102 of the light-emitting diode and enter the environment. The wavelength of the light which may escape from the space of the light-emitting diode resonant cavity 102 (the so-called resonant wavelength) is determined by the properties of the resonant cavity. Specifically speaking, by adjusting the length of the resonant cavity 102, the number of pairs of the lower reflection unit stack layers 143 or the upper reflection unit stack layers 153 in the Bragg reflectors, and the composition of the first reflection unit 140 or of the second reflection unit 150, it is possible to control the resonant wavelength and the applicable color of the resonant cavity 102 of the semiconductor element 100.

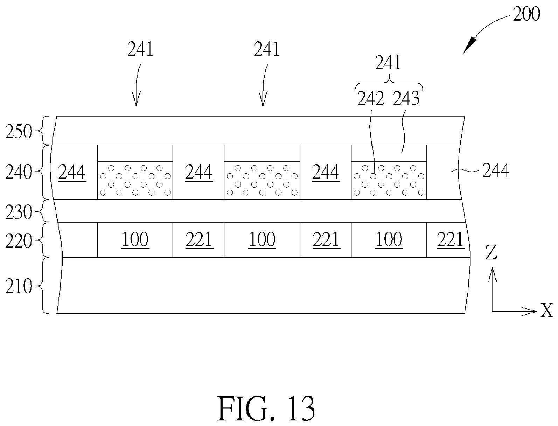

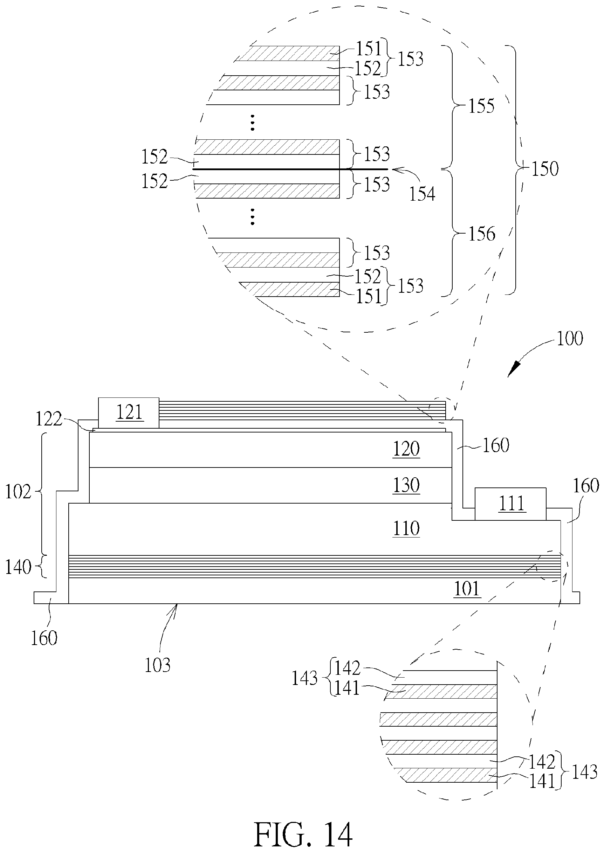

FIG. 13 and FIG. 14 are cross-sectional views of schematic structural diagrams of possible implementations of the electronic device 200 according to the eleventh embodiment of the present disclosure. The electronic device 200 shown in FIG. 13 may include the semiconductor element 100 shown in FIG. 14. The electronic device 200 may include a circuit substrate 210, a light-emitting layer 220, an optical adhesive layer 230, a color conversion layer 240 and a protection layer 250. The circuit substrate 210 may include a substrate (not shown) and a circuit layer (not shown), and the substrate is used to carry the circuit layer, and the circuit layer may include a transistor (not shown) electrically connected to the semiconductor element 100. For example, the transistor may be a thin film transistor (TFT) in charge of the on/off state of the semiconductor element 100. A first electrode layer (not shown) electrically connected to the transistor may be used to transfer the current from the transistor to the corresponding semiconductor element 100. In other embodiments, the above layers may optionally be added or removed, but the present disclosure is not limited thereto. A second electrode layer (not shown) may include a common electrode for a plurality of semiconductor elements 100.

In addition, the thin film transistor may also be used as a switching element for driving the semiconductor element 100 in the light-emitting layer 220. The thin film transistor may include a semiconductor layer (not shown), a drain (not shown), a source (not shown) and a gate (not shown). The semiconductor layer may include semiconductor material, such as silicon or metal oxide, but the present disclosure is not limited thereto. For example, the semiconductor layer may include amorphous silicon, polycrystalline silicon such as low-temperature polycrystalline silicon (LTPS), or an oxide semiconductor such as indium gallium zinc oxide (IGZO) or indium gallium oxide (IGO), but the present disclosure is not limited thereto. The semiconductor layer may include a source contact region, a drain contact region, and a channel region disposed between the source contact region and the drain contact region in a thin film transistor, corresponding to the gate. The drain electrode and the source electrode are respectively electrically connected to the semiconductor layer. The gate is segregated from the channel region by a gate dielectric layer (not shown). The gate, source, and drain may include conductive materials (such as metal, but the present disclosure is not limited thereto). Please note that the above structure is for example only and does not limit the possible types or structures of the thin film transistor of the present disclosure, so any other suitable thin film transistor structure is possible to replace the above thin film transistor. For example, a top gate thin film transistor or a bottom gate thin film transistor may be used as the thin film transistor in alternative embodiments.

The light-emitting layer 220 may include semiconductor elements 100, pixel definition layers (PDL) 221, and optional spacers (not shown) which are alternately arranged in a lateral direction, and adjacent semiconductor elements 100 may be segregated by pixel definition layers 221. The semiconductor element 100 may be a light-emitting element disposed on the circuit substrate 210. The optional spacers may be correspondingly provided with respect to the pixel defining layer 221 so as not to block a light-emitting region. In one embodiment, the semiconductor element 100 may include a light-emitting diode (LED), a micro light-emitting diode (micro LED), a sub-millimeter light-emitting diode (mini LED), or a quantum dot light-emitting diode (QLED), fluorescence, phosphor or other suitable materials and the materials may be optionally arranged and combined, but the present disclosure is not limited thereto. The semiconductor element 100 may be used to emit monochromatic light with a particularly narrow full width at half maxima of the main peak (maximum peak), such as blue light, to obtain better optical performance, but the present disclosure is not limited thereto.

The optical adhesive layer 230 may include a substantially transparent optical clear resin (OCR), which is used to bond the material layers above or below the optical adhesive layer 230 together without substantially affecting the luminous intensity of the electronic device 200. The color conversion layer 240 may include a color conversion element 241 and a light-shielding element 244. The color conversion element 241 may include a light conversion unit 242 and/or a color filter unit 243. The light conversion unit 242 may be located in the normal direction of the circuit substrate 210, such as the Z direction in FIG. 13, and overlap the semiconductor element 100 to adjust the output light of the electronic device 200. The plurality of color conversion elements 241 may be provided on at least part of the plurality of semiconductor elements 100. In one embodiment, a plurality of color conversion elements 241 may be respectively correspondingly disposed on a plurality of semiconductor elements 100. For example, a color conversion element 241 is provided on a semiconductor element 100, but the present disclosure is not limited thereto. In another embodiment, the plurality of color conversion elements 241 may be disposed on only a part of the plurality of semiconductor elements 100. Or alternatively, in yet another embodiment, not every semiconductor element 100 has a color conversion element 241 disposed thereon, but the present disclosure is not limited thereto. In some embodiments, the multiple color conversion elements 241 in FIG. 13 may respectively emit light of different wavelengths.

The light conversion unit 242 may include quantum dots, phosphorescent materials, or dyes, but the present disclosure is not limited thereto. The quantum dots may be composed of semiconductor nanocrystal structures and may include CdSe, CdS, CdTe, ZnSe, ZnTe, ZnS, HgTe, InAs, Cd₁₋ₓZnₓSe_{1-y}S_{y}, CdSe/ZnS, InP and GaAs, but the present disclosure is not limited thereto. The particle size of quantum dots is usually between 1 nanometer to 30 nanometers, 1 nanometer to 20 nanometers, or 1 nanometer to 10 nanometers. When a quantum dot is excited by input light, the input light is converted by the quantum dot into emitted light of other colors. The color of the emitted light may be tuned by changing the materials or size of the quantum dots. In some embodiments, the quantum dots may include spherical particles, rod-shaped particles, or particles with any other suitable shape, as long as the quantum dots may emit light with a suitable color. The light conversion unit 242 may be used to output visible light. For example, the light conversion unit 242 may output blue light, cyan light, green light, yellow light, red light, or the combinations thereof, but the present disclosure is not limited thereto.

The color filter unit 243 may be located in the normal direction of the circuit substrate 210, for example, in the Z direction perpendicular to the X direction in FIG. 13, and overlap the semiconductor element 100. The color filter unit 243 may include color filters. The color filters may enhance the purity of the monochromatic light output by the light conversion unit 242 to help the semiconductor element 100 improve its optical performance. The light-shielding element 244 may include a light-shielding material, such as a black matrix (BM) material or a combination of a black matrix material and a white material. The light-shielding element 244 may be used as a bank, but the present disclosure is not limited thereto. The light-shielding element 244 may be disposed between two adjacent light conversion units 242 to help reduce crosstalk of light from the adjacent light conversion units 242. In the present disclosure, the above output light may be regarded as the final visible light of the electronic device 200 perceived by the user (observer).

The protection layer 250 may be disposed on the plurality of color conversion elements 241 to reduce the chance of damage to the semiconductor element 100 or the color conversion element 241, for example, damage caused by moisture or oxygen. The protection layer 250 may be in the form of a single layer or a multi-layer structure, such as a stacked structure including multiple layers. In one embodiment, the protection layer 250 may include an inorganic layer, an organic layer, or a combination thereof. It is transparent to specific wavelengths of light, such as blue light, cyan light, green light, yellow light or red light.

The semiconductor element 100 illustrated in FIG. 14 may be a light-emitting element, for example, including an optional substrate 101, a first type semiconductor layer 110, a second-type semiconductor layer 120, a quantum well structure 130, a first reflection unit 140, a second reflection unit 150 and a passivation 160. The optional substrate 101 may be a substrate of an organic material or a substrate of an inorganic material. Please refer to the above for the details about the semiconductor element 100, and they are not elaborated here again.

In some embodiments, the first reflection unit 140 may include alternately stacked first lower reflection unit layers 141 and second lower reflection unit layers 142 to form a plurality of sets of lower reflection unit stack layers 143. The lower reflection unit stack layer 143 may include alternately stacked doped nano-porous semiconductor layers and undoped non-porous semiconductor layers to form a nano-porous Bragg reflector, but the present disclosure is not limited thereto. The nano-porous Bragg reflector helps increase the light extraction efficiency of the semiconductor element 100 and serves as a stress relief buffer layer to relief the quantum-confined Stark effect, thereby improving the external quantum efficiency of the semiconductor element 100. In some embodiments, the second reflection unit 150 may be a distributed Bragg reflector, for example, may include alternately stacked first upper reflection unit layers 151 and second upper reflection unit layers 152 to form a plurality of sets of upper reflection unit stack layers 153. The first upper reflection unit layer 151 and the second upper reflection unit layer 152 may respectively include different dielectric materials. For example, one of them may be tantalum oxide, and the other may be silicon oxide, but the present disclosure is not limited thereto. According to some embodiments of the present disclosure, the second reflection unit 150 includes a first Bragg reflector 155, a second Bragg reflector 156, and a middle layer 154 between the two. For example, the first Bragg reflector 155 or the second Bragg reflector 156 may also respectively include a plurality of mirror-symmetrically arranged upper reflection unit stack layers 153. The plurality of sets of mirror-symmetrically arranged upper reflection unit stack layers 153 may be symmetrically arranged according to the middle layer 154 in the second reflection unit 150 as the mirror axis.

In some embodiments, the quantum well structure 130 may include a pair of barrier layers (not shown), a first active layer (not shown), a second active layer (not shown), and a pair of optional third active layer (not shown) such that the second active layer is sandwiched between the first active layer and the optional third active layer. The first active layer, the second active layer and the third active layer may include, for example, gallium nitride semiconductor material. The concentration of Group 13 elements in the first active layer and in the third active layer may be different from the concentration of Group 13 elements in the second active layer. For example, the indium concentration of the first active layer and of the third active layer may be lower than the indium concentration of the second active layer. One of the characteristics of the quantum well structure 130 of the present disclosure resides in the indium concentration of the first active layer or the indium concentration of the third active layer is different from the indium concentration of the second active layer.

According to some embodiments of the present disclosure, the first type semiconductor layer 110 may be electrically connected to an external circuit via a pad electrode. For example, the first type semiconductor layer 110 may be connected to the transistors (not shown) in the circuit substrate 210 via an N-type electrode 111. Similarly, the second-type semiconductor layer 120 may be electrically connected to an external circuit via a transparent conductive layer and a pad electrode. For example, the second-type semiconductor layer 120 may be electrically connected to the transistors in the circuit substrate 210 via the transparent conductive layer 122 and the P-type electrode 121. The N-type electrode 111 and the P-type electrode 121 may respectively pass through the passivation 160 and be electrically connected to the transistor in the circuit substrate 210. The passivation 160 may be disposed on the transparent conductive layer 122 to reduce the chance of damage to the first type semiconductor layer 110, to the second type semiconductor layer 120, or to the quantum well structure 130, such as damage caused by moisture or oxygen. The passivation 160 may be in the form of a single layer or a multi-layer structure, such as a stacked structure including multiple layers, and is transparent to light of a specific wavelength, such as blue light, cyan light, green light, yellow light or red light. The semiconductor element 100 illustrated in FIG. 14 is a flip-chip type micro light-emitting diode, but the present disclosure is not limited thereto. FIG. 14 illustrates that the light-emitting surface 103 of the semiconductor element 100 is located on one side of the optional substrate 101, but the present disclosure is not limited thereto.

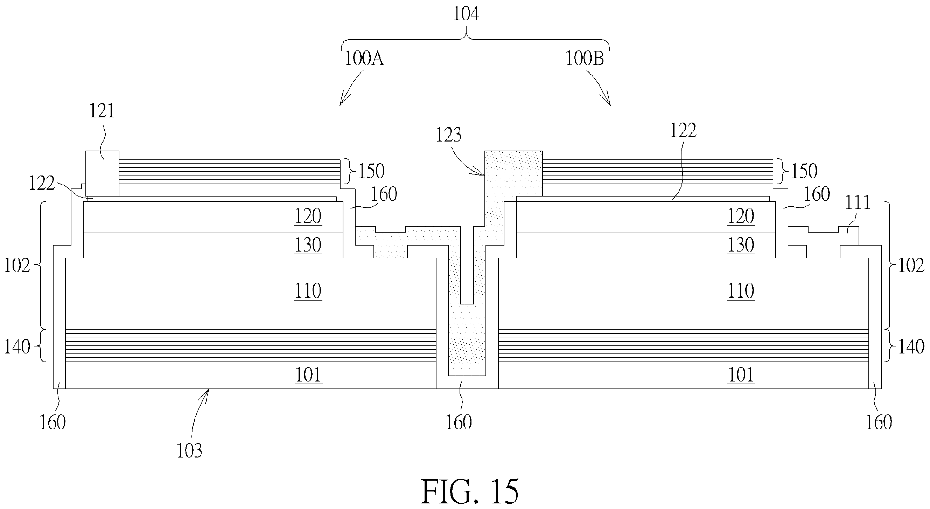

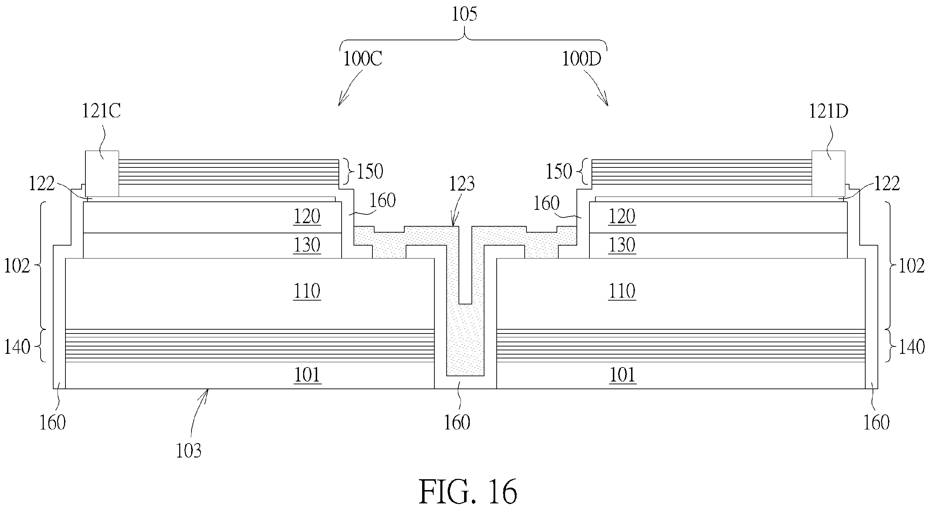

FIG. 15 is a cross-sectional view of a schematic structural diagram of a possible implementation of a semiconductor chip 104 according to the twelfth embodiment of the present disclosure. FIG. 15 illustrates that the semiconductor chip 104 of the present disclosure includes two of semiconductor element 100A and semiconductor element 100B, but the present disclosure is not limited thereto. FIG. 16 is a cross-sectional view of a schematic structural diagram of a possible implementation of a semiconductor chip 105 according to the thirteenth embodiment of the present disclosure. FIG. 16 illustrates that the semiconductor chip 105 of the present disclosure includes two of semiconductor element 100C and semiconductor element 100D, but the present disclosure is not limited thereto.

According to some embodiments of the present disclosure, each semiconductor element in the semiconductor chip 104 or in the semiconductor chip 105, such as the semiconductor element 100A, the semiconductor element 100B, the semiconductor element 100C or the semiconductor element 100D, may respectively include an optional substrate 101, a light-emitting surface 103, a first type semiconductor layer 110, an N-type electrode 111, a second-type semiconductor layer 120, a P-type electrode 121, a connection electrode 123, a quantum well structure 130, a first reflection unit 140, a second reflection unit 150 and a passivation 160.

One of the first type semiconductor layer 110 and the second type semiconductor layer 120 may be, for example, an N-type semiconductor layer, and the other may be, for example, a P-type semiconductor layer. The first type semiconductor layer 110 and the second type semiconductor layer 120 may include, for example, gallium nitride or other suitable semiconductor materials. The quantum well structure 130 is disposed between the first type semiconductor layer 110 and the second type semiconductor layer 120. In some embodiments, the quantum well structure 130 may include a pair of barrier layers (not shown), a first active layer (not shown), a second active layer (not shown) and an optional third active layer (not shown), so that the second active layer is sandwiched between the first active layer and the optional third active layer. The first active layer, the second active layer and the third active layer may include, for example, gallium nitride semiconductor material. The concentration of Group 13 element in the first active layer and in the third active layer may be different from the concentration of Group 13 element in the second active layer. For example, the indium concentration of the first active layer and of the third active layer is lower than the indium concentration of the second active layer. One of the characteristics of the quantum well structure 130 of the present disclosure resides in the indium concentration of the first active layer or the indium concentration of the third active layer different from the indium concentration of the second active layer.

According to some embodiments of the present disclosure, the first reflection unit 140 is disposed under the first type semiconductor layer 110. For example, the first type semiconductor layer 110 may be sandwiched between the first reflection unit 140 and the quantum well structure 130. The second reflection unit 150 is disposed on the second type semiconductor layer 120. For example, the second type semiconductor layer 120 may be sandwiched between the second reflection unit 150 and the quantum well structure 130. The space between the first reflection unit 140 and the second reflection unit 150 defines the resonant cavity 102 of each semiconductor element. The quantum well structure 130 is disposed in the resonant cavity 102, so that each semiconductor element may generate high-purity monochromatic light of a narrower emission spectrum according to the optical conditions defined by the first reflection unit 140 and by the second reflection unit 150. According to some embodiments of the present disclosure, the first reflection unit 140 or the second reflection unit 150 in the semiconductor element 100A, in the semiconductor element 100B, in the semiconductor element 100C or in the semiconductor element 100D may respectively optionally use a metal reflection unit with high reflectivity, for example, a silver mirror, but the present disclosure is not limited thereto. Using a metal reflection unit of high reflectivity helps increase the brightness of the light output by the semiconductor chip 104 or by the semiconductor chip 105 and improve its optical properties. Please refer to the above for the details of the semiconductor element 100 and they are not elaborated here again.

According to some embodiments of the present disclosure, the semiconductor chip 104 of the present disclosure shown in FIG. 15 is a dual-device light-emitting module in series. In other words, the two semiconductor element 100A and semiconductor element 100B are electrically connected in series. As shown in FIG. 15, the connection electrode 123 is electrically connected to the first type semiconductor layer 110 of the semiconductor element 100A and to the transparent conductive layer 122 of the semiconductor element 100B. When the semiconductor element 100A and the semiconductor element 100B are electrically connected in series, they share the same element current. The design of the two semiconductor element 100A and semiconductor element 100B connected in series is beneficial to increasing the overall luminous efficiency of the semiconductor chip 104 and/or simplifying the circuit layout design of the semiconductor chip 104.

According to some embodiments of the present disclosure, the semiconductor chip 105 of the present disclosure shown in FIG. 16 is a dual-device light-emitting module in parallel. In other words, the two semiconductor element 100C and semiconductor element 100D are electrically connected in parallel. As shown in FIG. 16, the connection electrode 123 is electrically connected to the first type semiconductor layer 110 of the semiconductor element 100C and to the first type semiconductor layer 110 of the semiconductor element 100D. When the semiconductor element 100A and the semiconductor element 100B are connected in parallel, semiconductor elements with different optoelectronic properties may be combined together and transferred at one time. The design of the two semiconductor element 100C and semiconductor element 100D in parallel is beneficial to independently controlling the optoelectronic properties of the respective semiconductor element 100C and semiconductor element 100D in the semiconductor chip 105. For example, the on/off state of respective semiconductor element 100C and semiconductor element 100D in the semiconductor chip 105 may be independently controlled. The dual-device in parallel semiconductor chip 105 may also facilitate the design of independent wide viewing angle/narrow viewing angle merged together. It should be noted that the materials of each layer, the thickness of each layer, the outline of each layer, the structures of the transistor, the circuit layout, etc. are only proposed for example, and their sizes or ranges are only for description, and the present disclosure is not limited thereto.

The semiconductor chips shown in FIG. 15 and in FIG. 16 of the present disclosure may be applied to the electronic device shown in FIG. 13. The semiconductor elements in other embodiments of the present disclosure may be replaced with the semiconductor elements or the semiconductor chips in FIG. 14 to FIG. 16.

In summary, the present disclosure provides a semiconductor element which emits high-purity monochromatic light with a narrow spectrum. The staggered quantum well structure in semiconductor elements may optimize the light-emitting quantum well band structure and achieve advantages such as reducing wavelength shift, increasing optical output power, or improving quantum efficiency. The thin film filter structure in the semiconductor element may help design the noise wavelength to be filtered, so it may further limit the width of the filtered light wavelength, which helps obtain emitted monochromatic light with the main peak of a particularly narrow full width at half maxima (FWHM) value for better optical performance. By combining the staggered quantum well structure with the resonant cavity of the thin film filter structure, the light-emitting element has both the staggered quantum well structure and the resonant cavity of the multi-layer film structure, and may achieve the synergistic result and the beneficial effect of obtaining monochromatic light of a narrowed full width at half maxima (FWHM) value and of converging the wavelength shift of the light-emitting diode at a high/low current, so the micro light-emitting diode with high efficiency and low color shift of the present disclosed may be achieved, thus helping to overcome the current various technical problems which are encountered in this field.

## Claims

1. A semiconductor element (100, 100A, 100B, 100C, 100D), **characterized by** comprising:
a first type semiconductor layer (110);
a second type semiconductor layer (120);
a quantum well structure (130) disposed between the first type semiconductor layer (110) and the second type semiconductor layer (120), and comprising a pair of barrier layers (139), as well as a first active layer (131) and a second active layer (132) which are disposed between the pair of barrier layers (139), and the first active layer (131) and the second active layer (132) respectively having Group 13 elements of different concentrations;
a first reflection unit (140) disposed under the first type semiconductor layer (110); and
a second reflection unit (150) disposed on the second type semiconductor layer (120) and defining a resonant cavity (102) with the first reflection unit (140),
wherein, the quantum well structure (130) is arranged in the resonant cavity (102).

2. The semiconductor element (100, 100A, 100B, 100C, 100D) of claim 1, **characterized in that** the quantum well structure (130) further comprises a third active layer (133), the second active layer (132) is disposed between the first active layer (131) and the third active layer (133), wherein a concentration of the Group 13 elements in the first active layer (131) and a concentration of Group 13 elements in the third active layer (133) are respectively smaller than a concentration of the Group 13 elements in the second active layer (132).

3. The semiconductor element (100, 100A, 100B, 100C, 100D) of claim 1 or claim 2, **characterized in that** the second reflection unit (150) comprises a first Bragg reflector (155), a second Bragg reflector (156) and a middle layer (154) between the first Bragg reflector (155) and the second Bragg reflector (156), wherein the first Bragg reflector (155) and the second Bragg reflector (156) form a mirror structure by using the middle layer (154) to serve as a mirror axis, and the first Bragg reflector (155) and the second Bragg reflector (156) are nano-porous Bragg reflectors (157).

4. The semiconductor element (100, 100A, 100B, 100C, 100D) of any one of claim 1 to claim 3, **characterized in that** the first reflection unit (140) is a nano-porous Bragg reflector (157), and the nano-porous Bragg reflector (157) comprises a plurality of alternately stacked nano-porous gallium nitride layers and gallium nitride layers.

5. The semiconductor element (100, 100A, 100B, 100C, 100D) of any one of claim 1 to claim 4, **characterized in that** the Group 13 elements of different concentrations and the resonant cavity (102) work together to have a synergistic effect.

6. The semiconductor element (100, 100A, 100B, 100C, 100D) of any one of claim 1 to claim 5, **characterized in that** an indium concentration of the first active layer (131) is different from an indium concentration of the second active layer (132).

7. The semiconductor element (100, 100A, 100B, 100C, 100D) of any one of claim to claim 6, **characterized in that** an indium to gallium ratio of the first active layer (131) is 0.155/0.845, and an indium to gallium ratio of the second active layer (132) is 0.33/0.67.

8. The semiconductor element (100, 100A, 100B, 100C, 100D) of any one of claim 1 to claim 7, **characterized in that** a thickness of the first active layer (131) is different from a thickness of the second active layer (132).

9. The semiconductor element (100, 100A, 100B, 100C, 100D) of any one of claim 1 to claim 8, **characterized by** having a staggered quantum well structure.

10. The semiconductor element (100, 100A, 100B, 100C, 100D) of any one of claim 1 to claim 9, **characterized by** having a thin film filter structure.

11. An electronic device (200), **characterized by** comprising:
a circuit substrate (210); and
a semiconductor element (100, 100A, 100B, 100C, 100D) of any one of claim 1 to claim 10 provided on the circuit substrate (210).

12. The electronic device (210) of claim 11, **characterized by** further comprising a light conversion unit (242) overlapping the semiconductor element (100, 100A, 100B, 100C, 100D) along a normal direction of the circuit substrate (210).

13. The electronic device (210) of claim 11 or claim 12, **characterized by** further comprising a color filter unit (243) overlapping the semiconductor element (100, 100A, 100B, 100C, 100D) along a normal direction of the circuit substrate (210).

14. The electronic device (210) of any one of claim 11 to claim 13, **characterized in that** the first reflection unit (140) comprises alternately stacked first lower reflection unit layers (141) and second lower reflection unit layers (142) to form a plurality of sets of lower reflection unit stack layers (143), and the lower reflection unit stack layer (143) comprises alternately stacked doped nano-porous semiconductor layers (158) and undoped non-porous semiconductor layers (159) to form a nano-porous Bragg reflector (157).

15. A semiconductor chip (104, 105), **characterized by**:
two semiconductor elements (100, 100A, 100B, 100C, 100D), each one of the semiconductor elements (100, 100A, 100B, 100C, 100D) comprising:
a first type semiconductor layer (110);
a second type semiconductor layer (120);
a quantum well structure (130) disposed between the first type semiconductor layer (110) and the second type semiconductor layer (120), comprising a pair of barrier layers (139) as well as a first active layer (131) and a second active layer (132) which are disposed between the pair of barrier layers (139), and the first active layer (131) and the second active layer (132) respectively comprising Group 13 elements of different concentrations;
a first reflection unit (140) disposed under the first type semiconductor layer (110); and
a second reflection unit (150) disposed on the second type semiconductor layer (120) and defining a resonant cavity (102) with the first reflection unit (140);
wherein, the quantum well structure (130) is arranged in the resonant cavity (102).
